# FASCICULE DE BREVET EUROPEEN

(11) **EP 1 572 575 B1**
(45) Date de publication et mention de la délivrance du brevet: **10.01.2018**
(21) Numéro de dépôt: 03810000.4
(22) Date de dépôt: 18.12.2003
(51) Int. Cl.: B81B 7/00

(54) **MICROSTRUCTURE ENCAPSULEE ET PROCEDE DE FABRICATION D'UNE TELLE MICROSTRUCTURE**
VERKAPSELTE MIKROSTRUKTUR UND DEREN HERSTELLUNGSVERFAHREN
ENCAPSULATED MICROSTRUCTURE AND METHOD OF PRODUCING ONE SUCH MICROSTRUCTURE

(30) Priorité: 20.12.2002 FR 0216331
(43) Date de publication de la demande: 14.09.2005
(73) Titulaire: Commissariat à l'Énergie Atomique et aux Énergies Alternatives, 75015 Paris (FR)
(72) Inventeur: DIEM, Bernard, 38130 Echirolles (FR); DELAPIERRE, Gilles, 38180 Seyssins (FR)
(74) Mandataire: Ahner, Philippe
(86) Numéro de dépôt international: PCT/FR2003/050189
(87) Numéro de publication internationale: WO 2004/058628

(56) Documents cités:
- EP-A- 0 451 992
- DE-A- 19 820 816
- US-A- 5 963 788
- US-A- 6 012 336
- US-B1- 6 452 238

## Description

### DOMAINE TECHNIQUE

La présente invention est relative à une microstructure, par microstructure on entend un composant obtenu par les technologies MEMS (abréviation anglo-saxonne de Micro Electro Mechanical System soit système microélectromécanique) ou les technologies connues sous l'abréviation plus générique de MST (abréviation anglo-saxonne de Micro System Technology soit technologie microsystème). Ces composants utilisent les technologies du micro-usinage des semiconducteurs et comportent sur un même substrat au moins un dispositif mécanique et/ou optique et/ou électromagnétique et/ou thermique et/ou fluidique combiné ou non à de l'électronique pour remplir une fonction déterminée. Ces microstructures ont connu leurs premiers développements dans les années 1970 et maintenant ont des applications commerciales notamment dans l'automobile, par exemple en tant qu'accéléromètre pour coussins de sécurité gonflables ou gyromètres ainsi que dans le domaine médical ou le domaine aérospatial.

### ÉTAT DE LA TECHNIQUE ANTÉRIEURE

Il existe deux grandes catégories de microstructures (qui peuvent se trouver sur un même substrat) : celles de type capteur qui mesurent une grandeur telle qu'une vitesse de rotation, une accélération, etc... et celles de type actionneur qui commandent une action, par exemple qui commandent un microrelais.

Ces microstructures comportent au moins un élément dit sensible ou transducteur qui est suspendu au-dessus du substrat. Il peut s'agir, par exemple du système pendulaire ou du bras d'un actionneur apte à se déplacer par rapport au substrat. En raison de ses petites dimensions, cet élément sensible et mobile est fragile, il doit être protégé par un capot de la poussière, de l'humidité, de la pression etc. en particulier au moment de la découpe des composants individuels puisque ces composants sont fabriqués par lots. Cet élément sensible doit être relié électriquement à un ou plusieurs plots de contact accessibles depuis l'extérieur du capot. Ces plots de contact peuvent être employés pour injecter un signal de commande à l'élément sensible ou au contraire pour récupérer une information provenant de l'élément sensible.

Un capot massif couvrant l'élément sensible peut être rapporté et scellé hermétiquement au substrat par exemple par du verre fusible comme dans le document [1] dont les références sont précisées à la fin de la description. Des plots de contact se trouvent à l'extérieur du capot, ils sont reliés à l'élément sensible par une connexion électrique qui est recouverte d'une couche de passivation, le joint de scellement du capot recouvre cette couche de passivation. L'inconvénient de ce capot est qu'il possède un joint de scellement large qui occupe une surface non négligeable à la surface du substrat, que sa pose et son scellement requièrent l'utilisation d'équipements spécifiques et qu'enfin son montage est éloigné des procédés classiques utilisés en microélectronique dans lesquels la fabrication se fait par lots à l'aide de procédés physico-chimiques (dépôt de couches minces et microlithographie).

Il a été proposé dans les documents [2] et [3] dont les références se trouvent en fin de description, de réaliser un capot recouvrant un résonateur par des techniques similaires à celle utilisées pour réaliser le résonateur : c'est à dire une succession d'étapes de dépôt, de gravure, de micro usinage ou de dissolution de matériaux à des endroits appropriés. La surface occupée sur le substrat est réduite. Mais dans ces documents les résonateurs sont obtenus avec des couches minces (sensiblement inférieures à 5 micromètres). La connexion électrique entre le résonateur et le plot de contact courre à la surface du substrat et le bord du capot se trouve à cheval sur la connexion électrique, laissant le plot de contact à l'extérieur pour qu'il puisse être accessible. Grâce à ces couches minces, la réalisation de la connexion électrique et du capot est compatible avec les techniques de fabrication par lots.

Mais les besoins s'orientent plutôt vers des microstructures plus épaisses (supérieures à environ 10 micromètres) et souvent microcristallines pour obtenir de meilleures performances. Dans ce cas, la réalisation des connexions électriques et celle du capot posent problème car l'élément sensible est séparé mécaniquement, par exemple par une tranchée, du plot de contact qui se trouve aussi sur le substrat. Une telle structure est visible sur le document [4] dont les références se trouvent en fin de description. Pour réaliser la connexion électrique entre l'élément sensible et le plot de contact, il faut franchir la tranchée. La tranchée peut être remplie localement de matériau diélectrique dans une zone qui va supporter la connexion électrique. Par rebouchage local, on entend un rebouchage en épaisseur mais pas obligatoirement sur toute la longueur de la tranchée.

Cette technique de rebouchage local de la tranchée pose un problème de rendement de fabrication et est susceptible d'introduire des zones de défauts.

Dans le document [5], dont les références se trouvent en fin de description, un pont à air est utilisé pour relier le sommet d'un élément sensible se trouvant sur un substrat à un plot de contact se trouvant sur le même substrat. L'élément sensible et le plot de contact ont des épaisseurs différentes, l'épaisseur de l'élément sensible étant supérieure à celle du plot. Du matériau diélectrique est déposé sur le substrat et le long du flanc de l'élément sensible pour servir de base au dépôt conducteur qui va constituer le pont à air. Ce matériau est ensuite ôté libérant le pont à air.

Si un capot est employé, il suffit de le déposer comme décrit dans les documents [2] ou [3] avant d'ôter le matériau servant de base au pont à air.

Le brevet US 6 452 238 décrit un dispositif micro-électro mécanique encapsulé sur un substrat semiconducteur.

Les brevets US 6 012 336 et US 5 963 788 décrivent des microstructures encapsulées avec un élément sensible et un capot qui est solidaire d'un substrat dans lequel est creusée une tranchée, l'élément sensible étant façonné dans une couche située dans la tranchée.

La demande de brevet DE 198 20 816 décrit une microstructure encapsulée dans laquelle le capot ne couvre pas le plot de contact relié électriquement à l'élément sensible.

Les inconvénients de ces techniques sont qu'elles sont complexes, qu'elles ont une incidence sur le rendement de fabrication, qu'elles conduisent à des microstructures dont le coût est élevé et qu'elles peuvent introduire des défauts dans les microstructures. Elles nécessitent en particulier l'emploi de deux couches suspendues l'une au-dessus de l'autre, l'une conduisant aux ponts à air, l'autre au capot.

### EXPOSÉ DE L'INVENTION

La présente invention a justement comme but de proposer une microstructure qui ne présente pas les inconvénients mentionnés ci-dessus.

Pour atteindre ces buts l'invention est une microstructures selon l'énoncé de la revendication 1. Elle comporte dans une première couche isolée d'un substrat par une couche isolante au moins un élément sensible relié à au moins un plot de contact par une connexion électrique et protégé par un capot. Selon l'invention, l'élément sensible, le plot de contact et la connexion forment un ensemble délimité dans la première couche par au moins une tranchée, cet ensemble étant recouvert par le capot, ledit capot comportant au moins une ouverture au-dessus du plot de contact et étant solidaire du plot de contact à la périphérie de l'ouverture et d'une zone située au-delà de la tranchée par rapport à l'ensemble.

Ainsi le capot recouvre tout l'ensemble en conservant une ouverture d'accès au plot de contact.

Le capot peut être scellé de façon étanche de manière à définir une cavité étanche dans laquelle se trouve l'élément sensible.

Dans cette configuration, le capot comporte au moins un orifice apte à être obturé par un bouchon de manière à pouvoir contrôler l'atmosphère de cette cavité.

La connexion électrique, le plot de contact et l'élément sensible sont de préférence réalisés dans un même matériau.

Le capot peut être réalisé en matériau diélectrique, en matériau conducteur ou semi-conducteur.

Pour faciliter la réalisation et éviter d'introduire des défauts provenant par exemple de différence de comportement entre des matériaux différents, il est préférable que l'ensemble incluant l'élément sensible et le capot soient réalisés dans un même matériau conducteur ou semi-conducteur.

On prévoit alors une couche diélectrique pour isoler le capot du plot de contact. De la même manière, une couche diélectrique isole le capot de la zone.

Pour faciliter la prise de contact, on peut prévoir que le plot de contact soit recouvert d'une plage conductrice au niveau de l'ouverture.

Dans un but de renforcement mécanique, le capot peut comporter au moins un pilier venant en appui sur une zone de l'élément sensible. Ce pilier a un rôle mécanique mais il peut aussi avoir un rôle électrique.

La zone de l'élément sensible sur laquelle s'appuie le pilier est de préférence solidaire du substrat.

Pour éviter que le capot ne se charge électriquement, il est possible de porter le capot au même potentiel qu'une partie de l'élément sensible, au même potentiel que le substrat ou que n'importe quel point préalablement choisi.

Le pilier en prenant appui sur une zone de l'élément sensible peut alors contribuer avec le capot à réaliser une connexion électrique de la zone.

Lorsque le capot est réalisé en matériau conducteur ou semi-conducteur, le pilier peut être isolé électriquement de l'élément sensible si le rôle du pilier n'est que mécanique.

La présente invention concerne également un procédé de fabrication d'une microstructure selon l'énonce de la revendication 15. Il comporte sur un substrat au moins un élément sensible relié à au moins un plot de contact par une connexion électrique.
Ce procédé comporte les étapes suivantes :
réalisation sur le substrat d'une première couche visant à former l'élément sensible, la connexion électrique et le plot de contact,
gravure de la première couche au contour de l'élément sensible, de la connexion électrique et du plot de contact de manière à ce qu'ils forment un ensemble délimité par au moins une tranchée,
réalisation au-dessus de la première couche gravée d'une couche sacrificielle et mise en forme pour former une empreinte d'un capot à déposer ultérieurement,
réalisation sur l'empreinte d'une seconde couche visant à former le capot et mise en forme de la seconde couche en gravant au moins une ouverture au-dessus du plot de contact, au moins un orifice par lequel est éliminée la couche sacrificielle, rendant le capot solidaire d'une part du plot de contact à la périphérie de l'ouverture et d'autre part d'une zone qui borde la tranchée au-delà de l'ensemble.

Un tel procédé a comme avantage d'être particulièrement simple et donc plus économique que les procédés conventionnels.

L'élimination de la couche sacrificielle peut libérer une cavité étanche définie par le capot, le procédé comporte une étape de réalisation d'un bouchon dans l'orifice après contrôle de l'atmosphère se trouvant dans la cavité.

Le procédé peut comporter avant l'étape de gravure de la première couche, une étape de dépôt d'une couche diélectrique sur le plot de contact pour isoler le capot du plot de contact autour de l'ouverture lorsque le capot est réalisé en matériau conducteur ou semi-conducteur.

Le procédé peut comporter avant l'étape de gravure de la première couche, une étape de dépôt d'une couche diélectrique sur la zone pour isoler le capot de la zone lorsque le capot est réalisé en matériau conducteur ou semi-conducteur.

L'étape de mise en forme de la couche sacrificielle peut prévoir la gravure d'au moins un puits visant réaliser un moule pour un pilier du capot Venant en appui sur une zone de l'élément sensible.

Lorsque le capot comporte au moins un pilier d'appui sur une zone de l'élément sensible et que le capot est conducteur ou semi-conducteur, la couche diélectrique peut aussi être déposée au niveau de la zone de l'élément sensible.

Le procédé peut comporter une étape de dépôt d'un matériau conducteur au sommet du plot de contact au niveau de l'ouverture pour améliorer la prise de contact.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A, 1B montrent en vue de dessus et en coupe AA une microstructure selon l'invention ;
- les figures 2A à 2H montrent des étapes de réalisation d'une microstructure selon l'invention.
- la figure 3 représente en vue de dessus une variante d'une microstructure selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

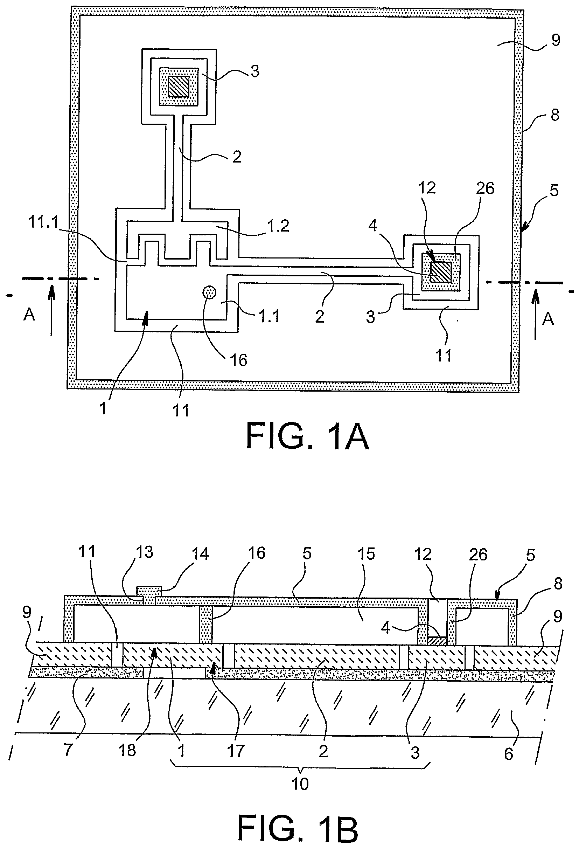

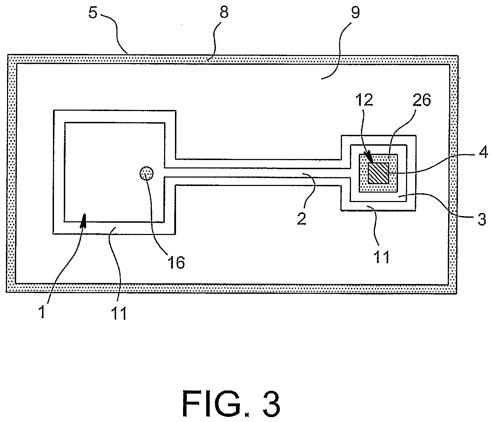

On se réfère aux figures 1A, 1B et à la figure 3. La microstructure qu'elles représentent comporte au moins un élément sensible 1 sur un substrat 6. Cet élément sensible 1 peut être par exemple une masse suspendue d'un capteur d'accélération. On aurait pu envisager que ce soit un bras d'un actionneur, une armature d'un dispositif à capacité variable, une paire d'électrodes interdigitées comme sur la figure 1A ou autre.

Cet élément sensible 1 peut être d'un seul tenant comme sur la figure 3 ou comporter plusieurs parties 1.1, 1.2 disjointes séparées par une tranchée 11.1 comme le montre la figure 1A. Parmi ces parties 1.1, 1.2 certaines peuvent être amenées à se déplacer par rapport au substrat 6 et d'autres pas.

Cet élément sensible 1 est destiné à être relié par l'intermédiaire d'au moins une connexion électrique 2 à un plot de contact 3. La connexion électrique 2, le plot de contact 3 et l'élément sensible 1 sont sur le même substrat 6. Ils sont de préférence en couche épaisse. Par couche épaisse, on entend une couche supérieure à environ 10 micromètres L'élément sensible 1, la connexion électrique 2 et le plot de contact 3 forment un ensemble 10 qui est délimité par une tranchée 11. Selon une caractéristique de l'invention, l'ensemble 10 est recouvert par un capot 5 qui est solidaire d'une zone 9 se trouvant au-delà de la tranchée 11 par rapport à l'ensemble 10. La zone 9 borde la tranchée au-delà de l'ensemble 10.

Par plot de contact, on entend une protubérance conductrice ou semi-conductrice qui contribue à réaliser un contact électrique. Lorsque le plot est en matériau semi-conducteur, comme on le suppose dans l'exemple décrit, il est préférable de coiffer le plot de contact 3 d'une plage conductrice de préférence métallisée 4 pour faciliter la prise de contact.

Le plot de contact 3, la connexion électrique 2 et l'élément sensible 1 sont réalisés dans un même matériau.

Lorsque l'élément sensible 1 comporte plusieurs parties disjointes 1.1, 1.2, on prévoit plusieurs connexions électriques 2 pour relier les différentes parties 1.1, 1.2 à des plots 3 de contact. Sur la figure 3 sur laquelle l'élément sensible 1 est d'un seul tenant, on a représenté qu'une seule connexion électrique 2 et qu'un seul plot de contact 3.

La connexion électrique 2 est monobloc avec une partie au moins de l'élément sensible 1 et/ou le plot de contact 3. L'expression « une partie au moins de l'élément sensible » englobe l'élément sensible qui est d'un seul tenant comme sur la figure 3. De préférence, ce sont la connexion électrique 2 et le plot de contact 3 qui sont monobloc.

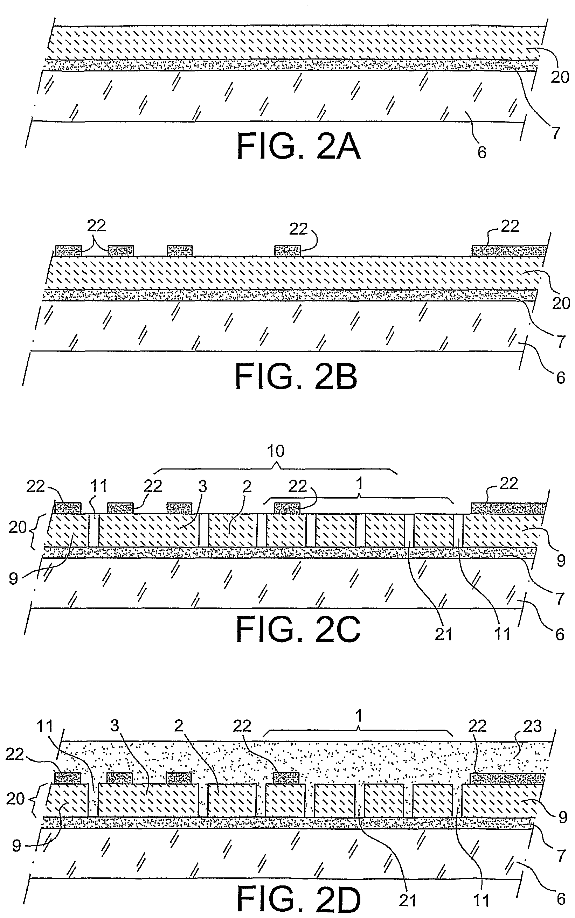

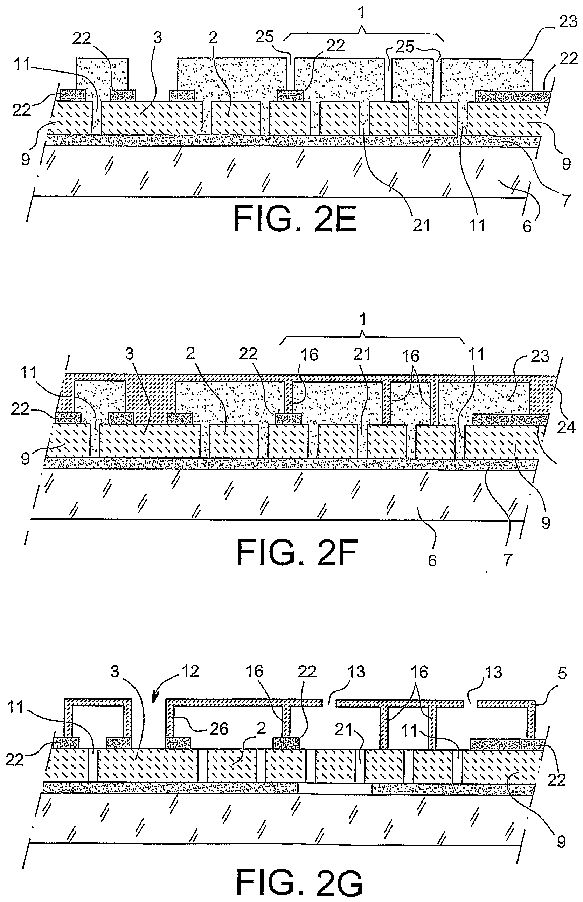

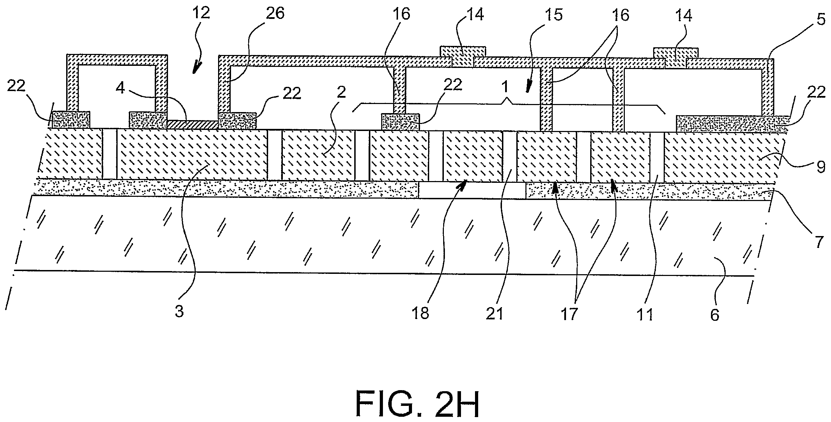

Dans d'autres configurations particulièrement simples à réaliser, comme sur la figure 1A et les figures 2, la connexion électrique 2 est monobloc avec à la fois une partie au moins de l'élément sensible 1 et le plot de contact 3. La connexion électrique 2 prolonge la partie de l'élément sensible 1 et se termine d'un seul tenant par le plot de contact 3.

L'ensemble 10 se trouve sur un substrat 6 recouvert partiellement ou totalement (au moins au début des étapes de fabrication) d'une couche sacrificielle 7. Ce substrat 6 et la couche sacrificielle 7 sont visibles sur la figure 1B. L'élément sensible 1, la connexion électrique 2 et le plot de contact 3 sont réalisés en matériau conducteur ou semi-conducteur. Pour faciliter la fabrication, il peut s'agir d'une couche de silicium d'un substrat dit SOI (abréviation anglo-saxonne de silicon on insulator soit silicium sur isolant). La couche sacrificielle 7 est alors la couche d'isolant du substrat SOI. Quant au substrat référencé 6 dans la présente description, il peut être une poignée fixée au substrat SOI. Dans une variante, le substrat 6 peut correspondre au silicium d'un substrat SOI, la couche sacrificielle 7 étant la couche isolante du substrat SOI.

Le capot 5 recouvre l'ensemble 10, c'est à dire à la fois l'élément sensible 1, la connexion électrique 2 et le plot de contact 3, ce n'était pas le cas dans l'art antérieur avec des couches minces car le bord du capot croisait la connexion électrique. Cette différence est importante car le croisement avec une connexion électrique ne peut se faire qu'avec des couches minces sinon on rencontre des problèmes d'étanchéité et/ou d'isolation électrique.

Le capot 5 possède un bord 8 qui est fixé au niveau de la zone 9. Cette zone 9 prend la forme d'un cadre 9 qui est disjoint de l'ensemble 10 par la tranchée 11 et qui est solidaire du substrat. Préférentiellement, le bord 8 du capot 5 est fixé hermétiquement au cadre 9 si l'élément sensible 1 doit se trouver dans un environnement différent de l'environnement ambiant.

L'ensemble 10 et le cadre 9 peuvent être réalisés par exemple par du silicium monocristallin déposé par épitaxie sur le substrat SOI.

Le capot 5 comporte, au niveau du plot de contact 3, une ouverture 12 qui permet d'accéder à la plage conductrice 4 et donc au plot de contact 3. Le capot 5 comporte une partie 26 solidaire du plot de contact 3 à la périphérie de l'ouverture 12. Lorsque le capot 5 est étanche, la partie 26 est fixée de manière étanche au plot de contact 3.

Le capot 5 contribue à délimiter une cavité 15 dans laquelle se trouve l'élément sensible 1 mais également une partie du plot de contact 3 et la connexion électrique 2. Cette cavité 15 peut ainsi être hermétique soumise à une atmosphère contrôlée par exemple le vide ou être emplie d'un fluide tel que l'air ou un gaz neutre, par exemple de l'argon ou de l'azote par exemple. Le capot 5 peut être équipé d'un orifice 13 qui permet notamment un accès à la cavité 15. Cet orifice est destiné à être obstrué par un bouchon 14 étanche lorsque la cavité 15 contient l'atmosphère appropriée. Ce bouchon 14 peut être réalisé par exemple en oxyde de silicium ou en verre de type PSG (sigle anglo-saxon pour phosphorus silicate glass soit verre de silice au phosphore).

Le capot 5 peut être réalisé dans un matériau diélectrique, c'est ce que l'on a voulu montrer sur la figure 1B.

Dans une variante particulièrement avantageuse, le capot 5 peut être réalisé dans un matériau conducteur ou semi-conducteur. Ce matériau peut être le même que celui de l'ensemble 10 notamment s'il s'agit de silicium polycristallin. Dans cette configuration, on insère entre le capot 5 et le plot de contact 3 une couche diélectrique 22 pour l'isoler électriquement dudit plot de contact 3. Cette configuration est illustrée sur la figure 2H. De la même manière on insère si nécessaire entre le bord 8 du capot 5 et la zone 9 du matériau diélectrique 22.

Le capot peut alors être utilisé pour interconnecter différentes zones 17 de l'élément sensible 1 et ceci par l'intermédiaire de piliers 16 qui font saillie dans la cavité 15 depuis le capot 5 et qui viennent chacun en contact électrique avec une zone de l'élément sensible 1. Ainsi plusieurs zones de l'élément sensible 1 peuvent être portées au potentiel du substrat par exemple ou au potentiel d'un point particulier par le biais du capot 5.

Le capot 5 sera réalisé dans un matériau choisi notamment pour sa résistance mécanique, il doit être capable de protéger l'élément sensible 1 pendant son utilisation même dans des conditions difficiles de pression, d'accélération ou de choc mais également pendant la fabrication de la microstructure. Il doit pouvoir encaisser des variations de pression et/ou de température. On peut utiliser pour réaliser le capot du silicium, du verre, du quartz, du métal par exemple. Un matériau qui convient bien est le silicium polycristallin.

Un avantage apporté par le fait que le capot 5 est réalisé dans un matériau conducteur ou semi-conducteur est qu'il peut être porté à un potentiel imposé en le reliant électriquement à au moins une zone 17 de l'élément sensible 1. Ce contrôle de potentiel permet d'éviter des variations de potentiel liées à l'environnement telles que des accumulations de charges électrostatiques. Cette liaison électrique peut être réalisée par au moins un pilier 16 qui prend appui sur la zone 17 de l'élément sensible 1.

Ce pilier 16 contribue également à assurer un maintien mécanique du capot 5 par rapport à l'élément sensible 1. On a vu plus haut que l'élément sensible 1 pouvait comporter au moins une partie mobile, cette partie correspond à une région 18 suspendue au-dessus du substrat 6.

Au niveau de la région 18 suspendue, le substrat 6 est exempt de couche sacrificielle 7. Il est préférable que la zone 17 au niveau de laquelle le pilier 16 prend appui ne soit pas une région 18 suspendue. Elle repose sur la couche sacrificielle 7 et est donc solidaire du substrat 6. Le pilier 16 assure un ancrage mécanique et cette caractéristique est avantageuse que le Capot 5 soit conducteur, semi-conducteur ou diélectrique. Un pilier 16 a été représenté sur les figures 1A, 1B. On suppose que son rôle n'est que mécanique puisque le capot est réalisé dans un matériau diélectrique.

Par contre lorsque le capot 5 est réalisé en matériau semi-conducteur ou conducteur, on peut donner à au moins un pilier 16 seulement un rôle de maintien mécanique et pas un rôle électrique. On isole alors le pilier 16 de l'élément sensible 1 par du matériau diélectrique 22. Un tel pilier 16 est visible sur la figure 2G. Le matériau diélectrique 22 est à sa base.

On va maintenant décrire un exemple de procédé de fabrication d'une microstructure selon l'invention. Dans l'exposé qui va suivre les différentes étapes emploient des techniques de dépôt, de masquage et de gravure classiques en microélectronique, c'est pourquoi elles ne sont pas détaillées mais elles ne posent aucun problème à un homme du métier.

On part d'un substrat 6 qui peut être en matériau semi-conducteur. On le recouvre d'une couche isolante sacrificielle 7 qui peut être en oxyde de silicium.

On recouvre la couche sacrificielle 7 d'une première couche 20 en matériau conducteur ou semi-conducteur, par exemple en silicium polycristallin ou en silicium monocristallin dans le cas d'un substrat SOI (figure 2A). Cette couche est une couche épaisse, elle peut avoir une épaisseur de l'ordre de 20 micromètres par exemple.

Si le capot 5, qui sera réalisé ultérieurement est conducteur ou semi-conducteur, on dépose au niveau des endroits où le capot va être fixé sur la première couche 20, des zones 22 en matériau isolant par exemple nitrure de silicium (figure 2B). Le nitrure de silicium est souvent préféré à l'oxyde de silicium car la gravure est sélective ce qui est intéressant lors de la gravure de la couche sacrificielle. Si le capot comporte un pilier qui doit être isolé électriquement de l'élément sensible, on dépose aussi une zone de matériau isolant 22 au niveau de la zone où le pilier va prendre appui sur l'élément sensible.

On-grave, par exemple par gravure ionique réactive, dans la première couche 20 le contour de l'élément sensible 1 et d'une ou plusieurs connexions électriques 2 destinées à coopérer chacune avec un plot de contact 3. L'élément sensible 1, la ou les connexions électriques 2 et le ou les plots 3 de contact forment un ensemble 10. Comme on l'a vu précédemment l'élément sensible 1 peut être en plusieurs parties 1.1, 1.2 distinctes et la connexion 2 est monobloc avec une partie au moins de l'élément sensible et/ou le plot de contact. Il est envisageable que l'élément sensible 1 comporte au moins un évidemment 21 dont l'utilité sera expliquée plus loin.

La gravure réalise donc la tranchée 11 qui entoure l'ensemble 10 et délimite par-là même le cadre 9 sur lequel le capot va venir se fixer.

La gravure réalise également la tranchée 11.1 qui sépare les parties distinctes de l'élément sensible.

Cette gravure s'arrête sur la couche sacrificielle 7 (figure 2C). Lorsque l'élément sensible 1 comporte une région 18 suspendue au-dessus du substrat 6, il est préférable de prévoir au niveau de la région 18 suspendue, la réalisation par gravure de l'évidemment 21 pour pouvoir réaliser ultérieurement une élimination de la couche sacrificielle 7 lors de la libération de la région 18 suspendue.

On recouvre la première couche 20 ainsi gravée et les éventuelles zones 22 d'une seconde couche sacrificielle 23 (figure 2D). Cette seconde couche sacrificielle 23 peut être réalisée dans le même matériau que la première couche sacrificielle 7, elle peut être par exemple en verre de silice au phosphore. Cette seconde couche sacrificielle 23 sert à planariser la surface et d'empreinte au capot qui va être réalisé ensuite. Cette seconde couche sacrificielle 23 va être modelée en fonction de la forme que doit avoir l'intérieur du capot. On va donc graver cette seconde couche sacrificielle 23 aux endroits où le capot doit venir en contact (direct ou indirect) avec d'une part le plot de contact 3 éventuellement l'élément sensible 1 et d'autre part le cadre 9 (figure 2E). Comme sur la figure 1B, le capot 5 possédera des piliers 16 d'appui sur l'élément sensible 1. On prévoit donc de graver dans la seconde couche sacrificielle 23 des puits 25 qui servent de moule aux piliers 16 (figure 2E). On remarque que le fond d'un des puits (celui de gauche) s'arrête sur une zone 22 tandis que le fond des deux autres s'arrête sur la première couche 20. Le pilier de gauche va être isolé électriquement de l'élément sensible mais pas les autres.

On dépose ensuite une seconde couche 24 destinée à réaliser le capot 5. Cette seconde couche peut être isolante, conductrice ou semi-conductrice. Elle peut être par exemple du verre, du quartz, du métal, du silicium et notamment du silicium polycristallin (figure 2F). Cette seconde couche 24 remplit les endroits évidés de la seconde couche sacrificielle 23 comme les puits 25. Cette seconde couche 24 est ensuite gravée au contour du capot 5, on dégage ainsi au moins une ouverture 12 au-dessus du plot de contact 3 pour réaliser l'accès au plot de contact et au moins un orifice 13 qui va servir lors de l'élimination de la seconde couche sacrificielle 23 et de la première couche sacrificielle 7 et qui va créer la cavité 15 dans laquelle on peut prévoir une atmosphère contrôlée (figure 2F).

On va éliminer par exemple par gravure chimique sélective à base d'acide fluorhydrique la seconde couche sacrificielle 23 pour mettre à nu les piliers 16 et vider de matériau la cavité 15. Lors de cette étape ou d'une étape ultérieure la première couche 7 sacrificielle est également éliminée localement pour libérer la région 18 suspendue de l'élément sensible 1 par rapport au substrat 6. L'élimination des deux couches sacrificielles 7, 13 peut se faire en même temps notamment si elles sont réalisées dans le même matériau. Les deux faces de l'élément sensible 1 sont alors soumises à un même environnement.

Si la cavité 15 doit être soumise à une atmosphère contrôlée, cette dernière est mise en place à partir de l'orifice 13, il peut s'agir du vide ou d'un fluide approprié tel un gaz neutre ou d'un fluide tel que l'air à une pression contrôlée. Il faut ensuite réaliser une obturation de chaque orifice 13 par un bouchon 14. Le bouchon peut être réalisé en oxyde, par exemple de l'oxyde de silicium ou en verre de silice au phosphore.

On réalise si nécessaire la plage conductrice (métallisée) 4 au sommet du plot de contact 3 (figure 2H).

### DOCUMENTS CITES:

[1] « Anodic bonding of evaporated glass structured with lift-off technology for hermetically sealing » S. Sassen, W. Kupke, K. Bauer, Transducers '99, June 7-10, 1999, Sendai Japan, pages 1320-1323.
[2] « Vacuum-Encapsulated Lateral Microresonators » L. Lin, K.M. McNair, R. T. Howe, A.P. Pisano, the 7th International Conference on Solid-State Sensors and Actuators, 1993, pages 270-273.
[3] « The application of fine-grained, tensile polysilicon to mechanically resonant transducers » H. Guckel, J.J. Sniegowski, T.R. Christenson, F. Raissi, Sensors and actuators, A21-A23 (1990), pages 346-351.
[4] « Advanced micromachined sensors », B. Sulouff, H. Geitner, Mstnews n°1/01 page 34.
[5] « 120 GHz long wavelength low capacitance photodetector with an air bridged coplanar metal waveguide » I-H. Tan, C-K. Sun, K. S. Giboney, J. E. Bowers, E. L. Hu, B. I. Miller, R. J. Capik, IEEE Photonics Technology Letters, vol. 7, n°12, december 1995.

## Revendications

1. Microstructure comportant dans une première couche (20) isolée d'un substrat (6) par une couche isolante (7) au moins un élément sensible (1) relié à au moins un plot de contact (3) par une connexion électrique (2) et protégé par un capot (5), où l'élément sensible (1), la connexion électrique (2) et le plot de contact (3) sont réalisés dans la première couche (20) et forment un ensemble (10) délimité par au moins une tranchée (11) gravée dans la première couche, cet ensemble (10) étant recouvert par le capot (5 ), **caractérisée en ce que** ladite tranchée (11) entoure l'ensemble et que ledit capot comporte au moins une ouverture (12) au-dessus du plot de contact (3) et est fixé à la première couche d'une part au niveau du plot de contact (3) à la périphérie de l'ouverture (12) et d'autre part au niveau d'une zone (9) de la première couche qui borde la tranchée (11) et qui est située au-delà de la tranchée (11) par rapport à l'ensemble (10).

2. Microstructure selon la revendication 1, **caractérisé en ce que** le capot (5) est scellé de façon étanche de manière à définir une cavité (15) étanche dans laquelle se trouve l'élément sensible (1).

3. Microstructure selon la revendication 2, **caractérisée en ce que** le capot (5) comporte au moins un orifice (13) apte à être obturé par un bouchon (14) de manière à pouvoir contrôler l'atmosphère de cette cavité (15).

4. Microstructure selon l'une des revendications 1 à 3, **caractérisée en ce que** la connexion électrique (2), le plot de contact (3) et l'élément sensible (1) sont réalisés dans un même matériau.

5. Microstructure selon l'une des revendications 1 à 4, **caractérisée en ce que** le capot (5) est réalisé en matériau diélectrique.

6. Microstructure selon l'une des revendications 1 à 4, **caractérisée en ce que** le capot (5) est réalisé en matériau semi-conducteur ou conducteur.

7. Microstructure selon la revendication 6, **caractérisée en ce que** l'ensemble (10) et le capot (5) sont réalisés en un même matériau conducteur ou semi-conducteur.

8. Microstructure selon l'une des revendications 6 ou 7, **caractérisée en ce qu'**une couche diélectrique (22) isole le capot (5) du plot de contact (3).

9. Microstructure selon l'une des revendications 6 à 8, **caractérisée en ce qu'**une couche diélectrique (22) isole le capot (5) de la zone (9).

10. Microstructure selon l'une des revendications 1 à 9, **caractérisée en ce que** le plot de contact (3) est recouvert d'une plage conductrice (4) au niveau de l'ouverture (12).

11. Microstructure selon l'une des revendications 1 à 10, **caractérisée en ce que** le capot (5) comporte au moins un pilier (16) venant en appui sur une zone (17) de l'élément sensible (1).

12. Microstructure selon la revendication 11, **caractérisée en ce que** la zone (17) de l'élément sensible est solidaire du substrat (6).

13. Microstructure selon l'une des revendications 11 ou 12, **caractérisée en ce que** lorsque le capot (5) est réalisé en matériau conducteur ou semi-conducteur, il comporte au moins un pilier (16) qui prend appui sur une zone (17) de l'élément sensible (1), le capot (5) et le pilier (16) contribuant à réaliser une connexion électrique de la zone.

14. Microstructure selon l'une des revendications 11 ou 12, **caractérisée en ce que** lorsque le capot (5) est réalisé en matériau conducteur ou semi-conducteur, le pilier (16) est isolé électriquement de l'élément sensible (1).

15. Procédé de fabrication d'une microstructure comportant sur un substrat (6) au moins un élément sensible (1) relié à au moins un plot de contact (3) par une connexion électrique (2), comportant les étapes suivantes :
réalisation sur le substrat (6) d'une première couche (20) visant à former l'élément sensible (1), la connexion électrique (2) et le plot de contact (3),
gravure de la première couche (20) au contour de l'élément sensible (1), de la connexion électrique (2) et du plot de contact (3) de manière à ce qu'ils forment un ensemble (10) délimité par au moins une tranchée (11) gravée dans la première couche (le procédé étant **caractérisé en ce que** la tranchée entoure l'ensemble (10), et **en ce qu'**il comporte les étapes suivantes :
réalisation au-dessus de la première couche (20) gravée d'une couche sacrificielle (23) et mise en forme pour former une empreinte d'un capot (5) à déposer ultérieurement,
réalisation sur l'empreinte d'une seconde couche (24) visant à former le capot (5) et mise en forme de la seconde couche (24) en gravant au moins une ouverture (12) dans ladite couche sacrificielle (23) au-dessus du plot de contact (3), une ouverture dans ladite couche sacrificielle (23) au-dessus d'une zone (9) de la première couche (20) qui borde la tranchée (11), située au-delà de la tranchée (11) par rapport à l'ensemble (10) et au moins un orifice (13) dans la seconde couche (24) par lequel est éliminée la couche sacrificielle (23), rendant le capot (5) solidaire de la première couche au niveau d'une part du plot de contact (3) à la périphérie de l'ouverture (12) et d'autre part d'une zone (9) de la première couche (20) qui borde la tranchée (11), située au-delà de la tranchée (11) par rapport à l'ensemble (10).

16. Procédé selon la revendication 15, **caractérisé en ce que** l'élimination de la couche sacrificielle (23) libère une cavité étanche (15) définie par le capot (5), il comporte une étape de réalisation d'un bouchon (14) dans l'orifice (13) après contrôle de l'atmosphère se trouvant dans la cavité (15).

17. Procédé selon l'une des revendications 15 ou 16, **caractérisé en ce qu'**il comporte, avant l'étape de gravure de la première couche (20), une étape de dépôt d'une couche diélectrique (22) sur le plot de contact (3) pour isoler le capot (5) du plot de contact (3) autour de l'ouverture (12) lorsque le capot (5) est réalisé en matériau conducteur ou semi-conducteur.

18. Procédé selon l'une des revendications 15 à 16, **caractérisé en ce qu'**il comporte, avant l'étape de gravure de la première couche (20), une étape de dépôt d'une couche diélectrique (22) sur la zone (9) pour isoler le capot (5) de la zone (9) lorsque le capot (5) est réalisé en matériau conducteur ou semi-conducteur.

19. Procédé selon l'une des revendications 15 à 18, **caractérisé en ce qu'**il comporte une étape de dépôt d'un matériau conducteur (4) au sommet du plot de contact (3) au niveau de l'ouverture (12).

20. Procédé selon l'une des revendications 15 à 19, **caractérisé en ce que** l'étape de mise en forme de la couche sacrificielle (23) prévoit la gravure d'au moins un puits (25) visant réaliser un moule pour un pilier (16) du capot (5) le reliant à l'élément sensible (1).

21. Procédé selon la revendication 20 reliée à la revendication 18, **caractérisé en ce que** lorsque le capot (5) comporte au moins un pilier d'appui (16) sur une zone (17) de l'élément sensible (1) et que le capot (5) est conducteur ou semi-conducteur, la couche diélectrique (22) est aussi déposée au niveau de la zone (17) de l'élément sensible (1).

## Patentansprüche

1. Mikrostruktur, die in einer durch eine Isolierschicht (7) von einem Substrat (6) isolierten ersten Schicht (20) zumindest ein empfindliches Element (1) aufweist, das über eine elektrische Verbindung (2) mit zumindest einem Kontaktstück (3) verbunden ist und von einer Schutzkappe (5) geschützt wird, wobei das empfindliche Element (1), die elektrische Verbindung (2) und das Kontaktstück (3) in der ersten Schicht (20) ausgebildet sind und eine Einheit (10) bilden, die von zumindest einem in die erste Schicht eingeätzten Graben (11) begrenzt wird, wobei diese Einheit (10) von der Kappe (5) überdeckt wird, **dadurch gekennzeichnet, dass** der Graben (11) die Einheit umgibt und dass die Kappe zumindest eine Öffnung (12) über dem Kontaktstück (2) aufweist und an die erste Schicht einerseits im Bereich des Kontaktstücks (3) am Umfang der Öffnung (12) und andererseits im Bereich einer Zone (9) der ersten Schicht befestigt ist, welche an den Graben (11) angrenzt und bezüglich der Einheit (10) jenseits des Grabens (11) liegt.

2. Mikrostruktur nach Anspruch 1, **dadurch gekennzeichnet, dass** die Kappe (5) in dichter Weise verschlossen ist, so dass sie einen dichten Hohlraum (15) definiert, in welchem sich das empfindliche Element (1) befindet.

3. Mikrostruktur nach Anspruch 2, **dadurch gekennzeichnet, dass** die Kappe (5) zumindest eine Öffnung (13) aufweist, die dazu geeignet ist, von einem Stopfen (14) verschlossen zu werden, so dass die Atmosphäre dieses Hohlraums (15) kontrolliert werden kann.

4. Mikrostruktur nach einem der Ansprüche 1 bis 3, **dadurch gekennzeichnet, dass** die elektrische Verbindung (2), das Kontaktstück (3) und das empfindliche Element (1) aus einem gleichen Material ausgebildet sind.

5. Mikrostruktur nach einem der Ansprüche 1 bis 4, **dadurch gekennzeichnet, dass** die Kappe (5) aus einem dielektrischen Material ausgebildet ist.

6. Mikrostruktur nach einem der Ansprüche 1 bis 4, **dadurch gekennzeichnet, dass** die Kappe (5) aus einem Halbleiter- bzw. Leitermaterial ausgebildet ist.

7. Mikrostruktur nach Anspruch 6, **dadurch gekennzeichnet, dass** die Einheit (10) und die Kappe (5) aus einem gleichen Leiter- bzw. Halbleitermaterial ausgebildet sind.

8. Mikrostruktur nach einem der Ansprüche 6 oder 7, **dadurch gekennzeichnet, dass** eine dielektrische Schicht (22) die Kappe (5) vom Kontaktstück (3) isoliert.

9. Mikrostruktur nach einem der Ansprüche 6 bis 8, **dadurch gekennzeichnet, dass** eine dielektrische Schicht (22) die Kappe (5) von der Zone (9) isoliert.

10. Mikrostruktur nach einem der Ansprüche 1 bis 9, **dadurch gekennzeichnet, dass** das Kontaktstück (3) mit einem leitfähigen Abschnitt (4) im Bereich der Öffnung (12) überdeckt ist.

11. Mikrostruktur nach einem der Ansprüche 1 bis 10, **dadurch gekennzeichnet, dass** die Kappe (5) zumindest eine Stütze (16) enthält, die sich an einer Zone (17) des empfindlichen Elements (1) abstützt.

12. Mikrostruktur nach Anspruch 11, **dadurch gekennzeichnet, dass** die Zone (17) des empfindlichen Elements fest mit dem Substrat (6) verbunden ist.

13. Mikrostruktur nach einem der Ansprüche 11 oder 12, **dadurch gekennzeichnet, dass** dann, wenn die Kappe (5) aus einem Leiter- bzw. Halbleitermaterial ausgebildet ist, sie zumindest eine Stütze (16) enthält, die sich an einer Zone (17) des empfindlichen Elements (1) abstützt, wobei die Kappe (5) und die Stütze (16) dazu beitragen, eine elektrische Verbindung der Zone herzustellen.

14. Mikrostruktur nach einem der Ansprüche 11 oder 12, **dadurch gekennzeichnet, dass** dann, wenn die Kappe (5) aus einem Leiter- bzw. Halbleitermaterial ausgebildet ist, die Stütze (16) elektrisch von dem empfindlichen Element (1) isoliert ist.

15. Verfahren zum Herstellen einer Mikrostruktur, die an einem Substrat (6) zumindest ein empfindliches Element (1) aufweist, das über eine elektrische Verbindung (2) mit zumindest einem Kontaktstück (3) verbunden ist, umfassend die nachfolgenden Schritte:
Ausbilden einer ersten Schicht (20) auf dem Substrat (6) zwecks Bildung des empfindlichen Elements (1), der elektrischen Verbindung (2) und des Kontaktstücks (3),
Ätzen der ersten Schicht (20) auf die Kontur des empfindlichen Elements (1), der elektrischen Verbindung (2) und des Kontaktstücks (3), so dass sie eine Einheit (10) bilden, die von zumindest einem in die erste Schicht eingeätzten Graben (11) begrenzt wird, wobei das Verfahren **dadurch gekennzeichnet ist, dass** der Graben (11) die Einheit (10) umgibt und dass es nachfolgende Schritte umfasst:
Ausbilden einer Opferschicht (23) über der geätzten ersten Schicht (20) und Umformen zum Bilden einer Prägung für eine nachträglich anzubringende Kappe (5),
Ausbilden einer zweiten Schicht (24) auf der Prägung zwecks Bildung der Kappe (5) und Umformen der zweiten Schicht (24), indem zumindest eine Öffnung (12) in die Opferschicht (23) über dem Kontaktstück (3) eingeätzt wird und eine Öffnung in die Opferschicht (23) über einer Zone (9) der ersten Schicht (20) eingeätzt wird, die an den Graben (11) angrenzt und bezüglich der Einheit (10) jenseits des Grabens (11) liegt, und zumindest eine Öffnung (13) in die zweite Schicht (24), über welche die Opferschicht (23) beseitigt wird, wodurch die Kappe (5) fest mit der ersten Schicht einerseits im Bereich des Kontaktstücks (3) am Umfang der Öffnung (12) und andererseits im Bereich einer Zone (9) der ersten Schicht verbunden wird, welche an den Graben (11) angrenzt und bezüglich der Einheit (10) jenseits des Grabens (11) liegt.

16. Verfahren nach Anspruch 15, **dadurch gekennzeichnet, dass** die Beseitigung der Opferschicht (23) einen dichten Hohlraum (15) freigibt, der von der Kappe (5) definiert wird, und dass es einen Schritt zum Ausbilden eines Stopfens (14) in der Öffnung (13) nach Kontrolle der Atmosphäre umfasst, die sich in dem Hohlraum (15) befindet.

17. Verfahren nach einem der Ansprüche 15 oder 16, **dadurch gekennzeichnet, dass** es vor dem Schritt des Ätzens der ersten Schicht (20), einen Schritt des Aufbringens einer dielektrischen Schicht (22) auf das Kontaktstück (3) umfasst, um die Kappe (5) vom Kontaktstück (3) um die Öffnung (12) herum dann zu isolieren, wenn die Kappe (5) aus einem Leiter- bzw. Halbleitermaterial ausgebildet ist.

18. Verfahren nach einem der Ansprüche 15 bis 16, **dadurch gekennzeichnet, dass** es vor dem Schritt des Ätzens der ersten Schicht (20) einen Schritt des Aufbringens einer dielektrischen Schicht (22) auf die Zone (9) umfasst, um die Kappe (5) von der Zone (9) dann zu isolieren, wenn die Kappe (5) aus einem Leiter- bzw. Halbleitermaterial ausgebildet ist.

19. Verfahren nach einem der Ansprüche 15 bis 18, **dadurch gekennzeichnet, dass** es einen Schritt des Aufbringens eines Leitermaterials (4) an den Scheitel des Kontaktstücks (3) im Bereich der Öffnung (12) umfasst.

20. Verfahren nach einem der Ansprüche 15 bis 19, **dadurch gekennzeichnet, dass** der Schritt des Umformens der Opferschicht (23) das Ätzen zumindest eines Schachts (25) vorsieht, um eine Gießform für eine Stütze (16) der Kappe (5) auszubilden, welche sie mit dem empfindlichen Element (1) verbindet.

21. Verfahren nach Anspruch 20 in Verbindung mit Anspruch 18, **dadurch gekennzeichnet, dass** dann, wenn die Kappe (5) zumindest eine Stütze (16) zum Abstützen an einer Zone (17) des empfindlichen Elements (1) enthält und die Kappe (5) leitend bzw. halbleitend ist, die dielektrische Schicht (22) auch im Bereich der Zone (17) des empfindlichen Elements (1) aufgebracht wird.

## Claims

1. Microstructure comprising in a first layer (20) insulated from a substrate (6) by an insulator layer (7) at least one sensitive element (1) connected to at least one contact pad (3) by an electrical connection (2) and protected by a package cap (5), wherein the sensitive element (1), the electrical connection (2) and the contact pad (3) are made in the first layer (20) and form an assembly (10) delimited by at least one trench (11) etch in the first layer, said assembly (10) being covered by the package cap (5), **characterized in that** said trench encloses the assembly and that said package cap comprises at least one opening (12) above the contact pad (3) and being integral with the first layer at on the one hand the contact pad (3) on the edges of the opening (12) and at on the other hand a zone (9) located beyond the trench (11) in relation to the assembly (10).

2. Microstructure according to claim 1, **characterised in that** the package cap (5) is sealed in a leak tight manner in such a way as to define a leak tight cavity (15) in which is located the sensitive element (1).

3. Microstructure according to claim 2, **characterised in that** the package cap (5) comprises at least one orifice (13) capable of being sealed by a plug (14) in such a way as to be able to control the atmosphere of said cavity (15).

4. Microstructure according to claim 1, **characterised in that** the electrical connection (2), the contact pad (3) and the sensitive element (1) are formed in a same material.

5. Microstructure according to claim 1, **characterised in that** the package cap (5) is formed in dielectric material.

6. Microstructure according to claim 1, **characterised in that** the cap (5) is formed in semi-conductor or conductor material.

7. Microstructure according to claim 6, **characterised in that** the assembly (10) and the package cap (5) are formed in a same conductor or semi-conductor material.

8. Microstructure according to claim 6, **characterised in that** a dielectric layer (22) insulates the package cap (5) from the contact pad (3).

9. Microstructure according to claim 6, **characterised in that** a dielectric layer (22) insulates the package cap (5) from the zone (9).

10. Microstructure according to claim 1, **characterised in that** the contact pad (3) is covered with a conductive band (4) at the level of the opening (12).

11. Microstructure according to claim 1, **characterised in that** the package cap (5) comprises at least one pillar (16) resting on a zone (17) of the sensitive element (1).

12. Microstructure according to claim 11, **characterised in that** the zone (17) of the sensitive element is integral with the substrate (6).

13. Microstructure according to claim 11, **characterised in that** when the package cap (5) is formed in conductor or semi-conductor material, it comprises at least one pillar (16) that is resting on a zone (17) of the sensitive element (1), the package cap (5) and the pillar (16) contributing to forming an electrical connection with the zone.

14. Microstructure according to claim 11, **characterised in that** when the package cap (5) is formed in conductor or semi-conductor material, the pillar (16) is electrically insulated from the sensitive element (1).

15. Method of manufacturing a microstructure comprising on a substrate (6) at least one sensitive element (1) connected to at least one contact pad (3) by an electrical connection (2), wherein it comprises the following steps:
forming on the substrate (6) of a first layer (20) intended to form the sensitive element (1), the electrical connection (2) and the contact pad (3),
etching of the first layer (20) at the contours of the sensitive element (1), the electrical connection (2) and the contact pad (3) in such a way that they form an assembly (10) delimited by at least one trench (11) etched in the first layer,
the method being **characterized in that**:
the first etched layer (20) enclosed the assembly,
and **in that** it comprises the following step:
forming above the first layer etched of a sacrificial layer (23) and shaping to form an impression of a package cap (5) to be deposited subsequently,
forming on the impression a second layer (24) intended to form the package cap (5) and shaping of the second layer (24) by etching at least one opening (12) in said sacrificial layer (23) above the contact pad (3), at least one orifice (13) in said sacrificial layer (23) above a zone (9) of the first layer (20) which borders the trench (11), located beyond the trench (11) in relation to the assembly (10) and at least one orifice (13) in the second layer (24) through which is eliminated the sacrificial layer (23), making the package cap (5) integral with on the one hand the contact pad (3) on the edges of the opening (12) and on the other hand a zone (9) located beyond the trench (11) in relation to the assembly (10).

16. Method according to claim 15, **characterised in that** the elimination of the sacrificial layer (23) frees a leak tight cavity (15) defined by the package cap (5), it comprises a step of forming a plug (14) in the orifice (13) after controlling the atmosphere found in the cavity (15).

17. Method according to claim 15, **characterised in that** it comprises, before the step of etching of the first layer (20), a step of depositing a dielectric layer (22) on the contact pad (3) to insulate the package cap (5) from the contact pad (3) around the opening (12) when the package cap (5) is formed in conductor or semi-conductor material.

18. Method according to claim 15, **characterised in that** it comprises, before the step of etching of the first layer (20), a step of depositing a dielectric layer (22) on the zone (9) to insulate the package cap (5) from the zone (9) when the package cap (5) is formed in conductor or semi-conductor material.

19. Method according to claim 15, **characterised in that** it comprises a step of depositing a conductor material (4) at the summit of the contact pad (3) at the level of the opening (12).

20. Method according to claim 15, **characterised in that** the step of shaping of the sacrificial layer (23) provides for the etching of at least one sink (25) intended to form a mould for a pillar (16) of the package cap (5) connecting it to the sensitive element (1).

21. Method according to claim 18, **characterised in that** when the package cap (5) comprises at least one pillar (16) resting on a zone (17) of the sensitive element (1) and that the package cap (5) is conductor or semi-conductor, the dielectric layer (22) is also deposited at the level of the zone (17) of the sensitive element (1).
